Europäisches Patentamt

European Patent Office

Office européen des brevets

(19)

(11) Publication number: **0 041 928**

**A1**

(12) **EUROPEAN PATENT APPLICATION**

(21) Application number: **81830083.2**

(22) Date of filing: **26.05.81**

(51) Int. Cl.³: **H 05 K 13/04**

(30) Priority: **27.05.80 IT 4880080**
**30.04.81 IT 4837881**

(43) Date of publication of application:
**16.12.81 Bulletin 81/50**

(84) Designated Contracting States:
**BE DE FR GB NL SE**

(71) Applicant: **TECHNICONSULT S.r.l.**
**19, Via Giacinto Carini**
**I-00152 Rome(IT)**

(72) Inventor: **Cirillo, Francesco, Eng.**
**32, Via Giacinto Carini**
**I-00152 Rome(IT)**

(74) Representative: **Cioncoloni, Enrico, Dr.**
**Studio Consulenza Brevetti 76, Via F. Turati**
**I-00185 Rome(IT)**

(54) **A method to braze by the Joule effect an electroconductive element onto a silk-screen printed support or the like as well as a device and product relating the same.**

(57) The invention relates to a method and device to braze an electroconductive element onto a conductive coating deposited over a bearing surface through a conductive binding means interposed therebetween, so that said electroconductive element may be used as a terminal to be connected to an outer power source. According to this method, the junction of said electroconductive element with a conductive coating deposited over a bearing surface is provided by melting said binding means interposed therebetween in order that a single electroconductive body is formed. The heat to melt said binding means is generated in the brazing area because of the Joule effect provided between one or more pairs of suitably spaced pointed electrodes connected to a source of modulated low voltage. The pointed electrodes are suitably pressed onto said electroconductive element to be brazed, so that the circuit of the interconnected elements is in the ON state.

**FIG. 7**

COMPLETE DOCUMENT

Croydon Printing Company Ltd.

The present invention relates to a method for brazing electroconductive elements onto silk-screen printed bearing surfaces or the like, which is based on the Joule effect and contact resistance, as well as to a device to carry out the brazing of suitable electroconductive means.

According to the present invention, both method and device are exploiting the heat generated in the brazing area by the Joule effect provided between one or more pairs of electrodes which are operating onto a suitable electroconductive element to be brazed to any support, also a conductor, when an intermediate binding means is interposed therebetween, as this latter will be melt by that heat and the desired junction carried out.

A particular attention has however been devoted by the Applicant to the junction of an electroconductive element with a conductive coating deposited over an insulating bearing surface - for example by a silk-screen printing process - such a coating being eventually reinforced by a further galvanic deposition, so that the brazed electroconductive element may be used as a terminal for electrical connections.

It is also important today to turn one's attention to the junction of electroconductive elements in the field of printed circuits as well as thermal rear glasses of autovehicles, or windshield-antenna and the like which are more and more diffused and wherein the jointed electroconductive element acts as a terminal for the necessary connections to a power source.

Referring to this latter case of application, four
superposed, solidly jointed component members are to be
listed, namely: a base support comprising, for example,
the front or back glass of an autovehicle; a conductive
coating deposited over the surface of that base support,
for example by silk-screen printing process, according
to a suitable pattern and eventually reinforced by a
further galvanic deposition; an intermediate binding
means which is also made of a conductive material; and
finally the electroconductive element to act as a terminal in order that this electroconductive element may
connect the conductive coating to a power source.
As well known, the glass surface is not in this case a
plane surface, rather shaped according to the outward
appearance of the autovehicle and functions to be carried out. The conductive coating deposited over the glass
surface generally comprises a pigment of silver granules
in a vehicle of low-melting vetrifying materials, when
a silk-screen printing process has been preferred for
the deposition, while copper and nickel compounds or the
like are used for the deposition by galvanic process.
The thickness of these conductive coatings is in any case of a few microns only, so that a skilled in the art
may easily understand that the best care is to be shown
in brazing a suitable electroconductive element upon
such a conductive coating so that the necessary connections to a power source may actually be secured.
Many factors affect the brazing operation and particularly: the heat provided in the brazing area; the operational pressure upon that electroconductive element in order that a sure junction of this latter with the conductive coating of glass support as well as the electrical conductivity therebetween may be carried out through the intermediate binding means; the shape of glass support over the surface of which that conductive coating has been deposited.

On the other hand, when a brazing operation is to be performed as suggested and claimed in the present invention, i.e. by exploiting the heat generated because of the Joule effect, it is essential that the electrodes which are acting onto the electroconductive element to be jointed with the conductive coating of glass support through that binding means have by itself some suitable characteristics in regard to the material and shape and correspond to above factors.

The brazing operation for the junction of an electroconductive element with the conductive coating deposited over a shaped glass surface has generally been performed until now by acting manually. The drawbacks of such an operation are not only concerning the best care to be shown by the operator and a long experience of same in carrying out a welding which is "apparently" regular and satisfactory, but also the operational times, controls of above factors, impossibility of mass production and furthermore the relatively expensive working.

A main object of the present invention is to provide a method of brazing comprising operational stages to be carried out in a timed and automatic manner, by first of all exploiting the heat generated in the brazing area because of the Joule effect provided between suitably spaced electrodes when a modulated low voltage is supplied and these electrodes are suitably pressed onto the electroconductive element to be brazed upon a conductive coating through intermediate binding means. As well known, because of the Joule effect a certain quantity of heat is generated in the area of the electrodes wherein the electroconductive element is to be brazed and then transferred to that intermediate conductive binding means, so that this latter is melted between the opposed surfaces. A single solid unit is thus provided after the binding means is cooled.

Another object of the present invention is to provide a device the component members of which are controlled by a central drive in a timed and automatic manner, so that predetermined functions of same may be carried out, subsystems being also provided for pneumatic as well as auxiliary electromechanical operations by means of suitable devices.

Another object of the present invention is to supply a modulated low voltage to the electrodes, the value of which is initially higher and then abruptly lower after a predetermined time. The modulated low voltage values and times are previously regulated and then applied automatically.

A further object of the present invention is to provide an electroconductive element which is particularly suitable to be brazed onto a conductive coating deposited over the surface of an insulating support and then carry out the functions of a terminal. The electroconductive element together with the jointed conductive coating
may consequently be connected to a power source and the
features of this latter member may be efficiently used.
In order that the ground principles of the present invention may be better understood by the skilled in the
art and the real advantages of same may justly be considered in relation to the method and device, an embodiment is hereafter described as an example which is referred to the accompanying drawings. This embodiment concerns an exemplifying device to be used to joint an electroconductive element with a conductive coating which
has been deposited in a conventional manner over the surface of a glass support, for example the thermal rear
window of an autovehicle, the junction being carried
out by a brazing operation according to the method of
the present invention; that is to say by exploiting the
heat generated in the brazing area by the Joule effect,
and the consequent melting of a binding means interposed
between the opposed surfaces of the elements to be
jointed. A single solid unit is thereby obtained after
the binding means is cooled, and the electroconductive
element may then be used as a terminal to connect the
jointed conductive coating to a power source in order
that the thermal features of this latter may be utilized.

Description and drawings relate to an example only of
embodiment to evidence the novel features of the present
invention and not a limitation of same. Changes and/or
modifications are then possible and will also claimed when falling within the scopes of the invention.

In the drawings:

fig.1 is a schematic view of a brazing device to braze an electroconductive element onto a conductive coating deposited over the surface of a base support, that view being limited to the component members specifically provided in this embodiment, so that control as well as electronic means for automatic operations are excluded as do not fall within the scopes of the invention;

fig.2 is a schematic top view of the main component members of the brazing device head, some parts being removed and/or sectioned to better show some component members or features of same;

fig.3 is a schematic elevation view from the right side of fig.2 relating to the main component members of the device head, certain parts being removed and/or sectioned to better show some component members or features of same;

fig.4 is a schematic elevation view from the front side of fig.2 certain parts being yet removed and/or sectioned to better show some component members or features of same;

fig.5 shows detailed elevation and bottom views of one brazing pointed rod to be used as electrode in this device, according to the present invention so that brazing operations may be carried out in accordance with the method which is also object of the present invention;

fig.6 shows detailed side, front and top views of an electroconductive element to be used for junction purposes according to the described embodiment of the invention;

fig.7 is a front partly sectioned view of all the component members superposed in the brazing area, a pair of electrodes being also shown in the form of pointed rods of the device according to the present invention.

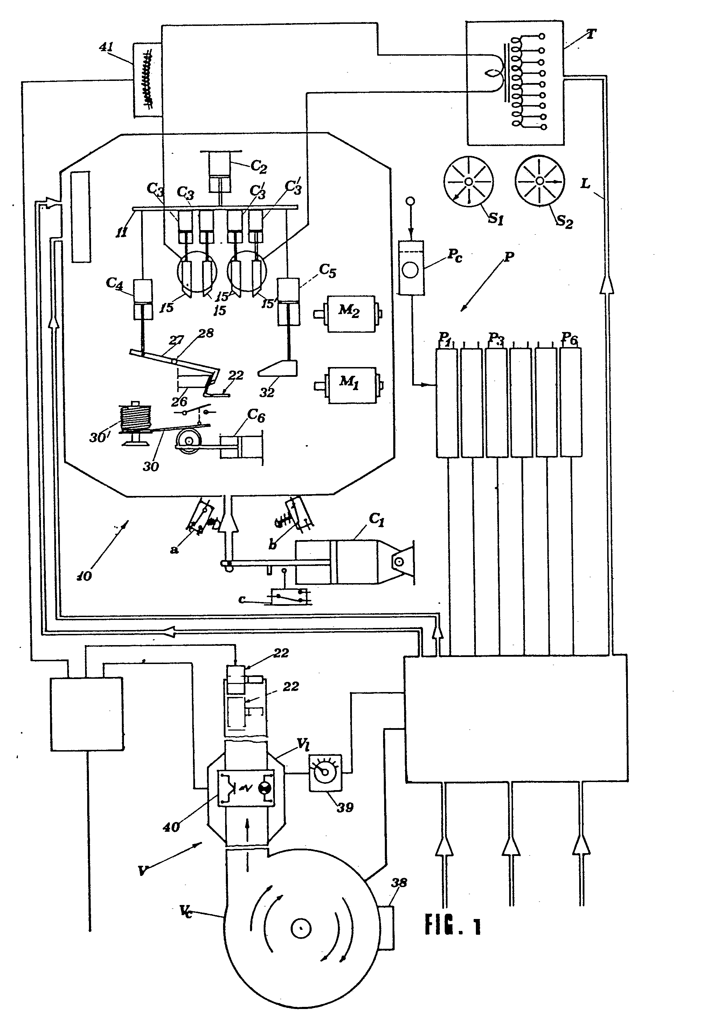

Referring now to the drawings and first of all to fig.1, the schematic view of same may give an idea of the provided operational brazing-head composition according to the embodiment hereafter described, a vibrating system V being also shown by which is possible to arrange in orderly alignment the electroconductive elements 22 to be consecutively brazed upon respective conductive coating deposited over the surface of a base support (e.g. a thermal rear glass of an autovehicle, not shown), by exploiting the heat generated in the brazing area by the Joule effect, in order to melt a binding means 30 interposed therebetween.

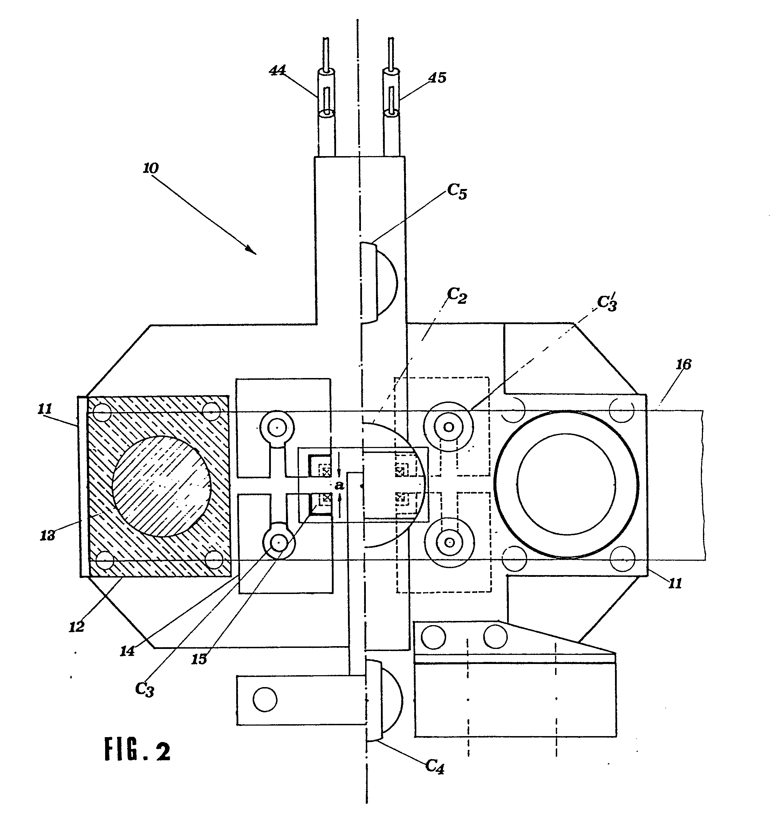

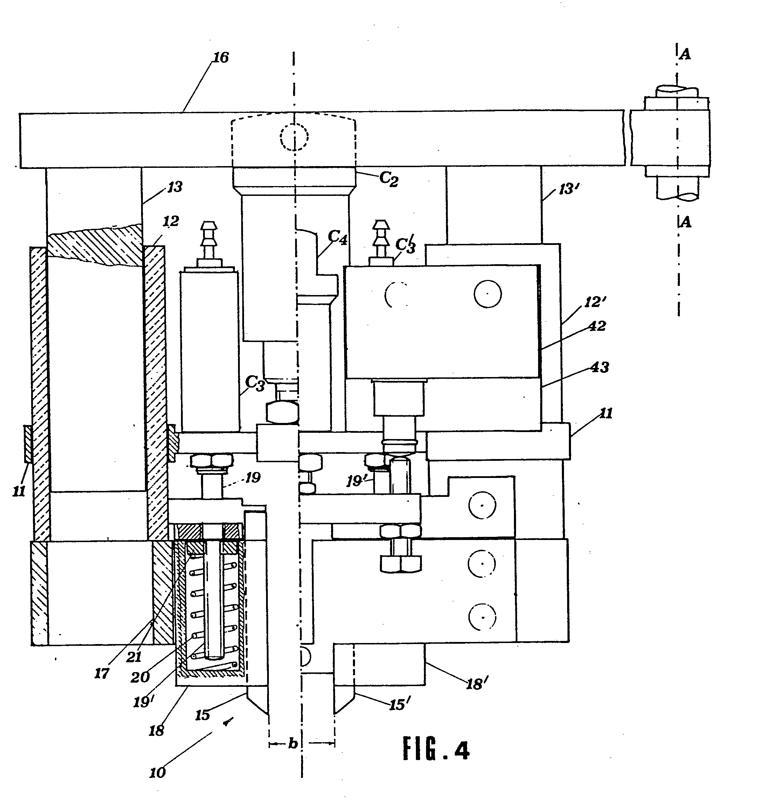

From the schematic view of fig.1 and elevation view of fig.4 it is first of all possible to notice that device head 11 together with the whole of its component members is revolving about axis A-A up to 90°, namely between limit stop switches $a$, $b$, that angular motion being controlled by cylinder-piston unit $C_1$ as a component member of central pneumatic system P, the motions of the piston of unit $C_1$ being, in turn, regulated by switch $c$. The limit stop positions correspond: to the drawing of an electroconductive element 22 from the outlet of rec-
tilinear section $V_1$ of vibrator V, its suitable tab 24
being then clamped against a shoulder 26 because of the
angular motion of a  suitable lever 27 about pin 28, as
it will be recalled hereafter; and putting that electroconductive element 22 down the pair or pairs of brazing
pointed rods 15-15, 15'-15' which  are operating onto
coplanar sections 23-23 thereof, two pairs of brazing
pointed rods being provided according to this embodiment.
Another important novel characteristic of device 10 is
to  be added to that described hereabove and illustrated
in figs.1 to 4, which relates to the angular motion of 90°
of  device head 11. That other characteristic relates
to the pending condition of the head and component members of device 10 as a unit from a bearing bar 16 in order to be moved about ideal axes which are perpendicular
to each other. In this manner the pointed ends of the
two pairs of pointed rods 15-15 and 15'-15' may be better positioned  during the downward motion of same as
it will be recalled hereafter,and an efficient action of
pointed rods may be provided also when that conductive
coating to be jointed has been deposited over a not-plane surface as generally occurs in the above cited cases
of front or rear glass of an autovehicle. It is thus possible to place the device head 11 in that position which
is more suitable for efficiently brazing an electroconductive element 22.

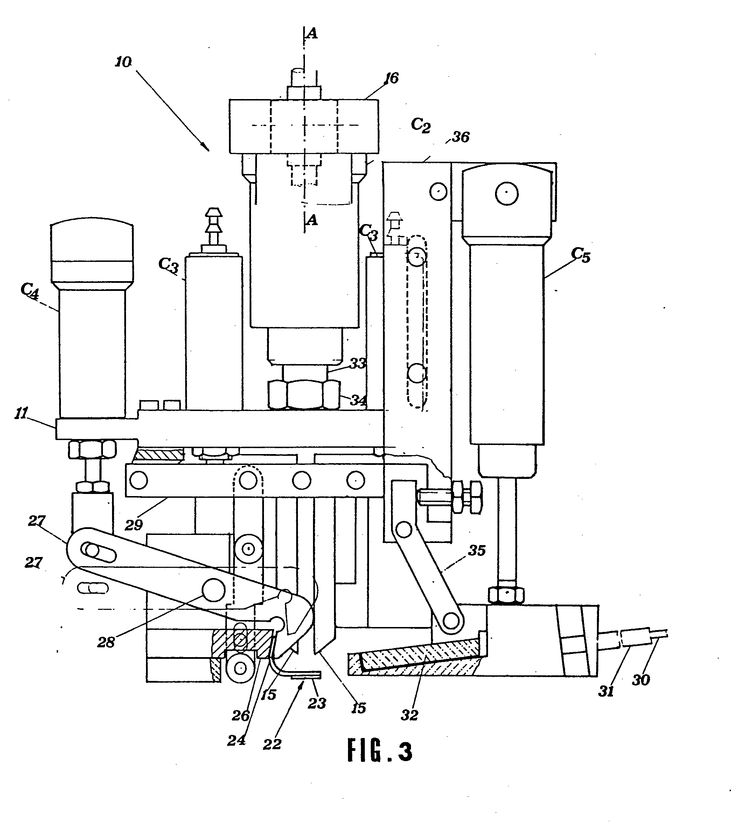

As shown in figs.1 and 3, device head 11 is connected
to piston rod 33 of cylinder-piston unit $C_2$ and clamped

thereon by means of a screw nut 34, so that the head
and component members thereof may be driven by said
unit $C_2$ for reciprocating motions.

According to the illustration of fig.4, cylindrical
pieces 16' are provided to guide such a motion, the respective top ends of which are clamped on bearing bar
16, while the guide by itself is obtained through tubular bushes 12 which are, in turn, connected to head 11
as a single body.

On the other hand, cylinder-piston units $C_3$ and $C_3$' are
also clamped on device head 11 and act to move the pairs
of brazing pointed rods 15-15 and 15'-15'. In fig.4 a partial section of the sliding rod-holder 18 is shown, in
order to also evidence what has been provided in this
example of embodiment, i.e. the use of an auxiliary disc
21 for the upward motion, as well as a cylindrical spiral spring 20 about bottom end 19' of stem 19 of the re-
spective cylinder-piston unit $C_3$.

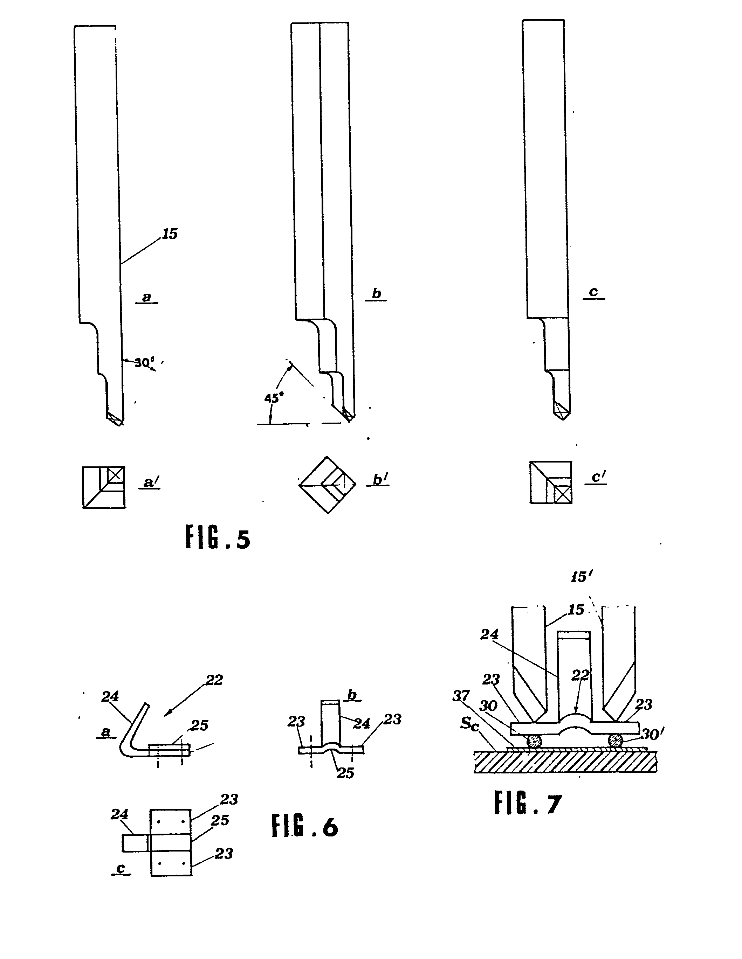

A further particular attention is to be addressed to
this sectional illustration of device 10 for what relates to the pointed rods and holders of same. Many characteristics are indeed to be evidenced as determinant to
carry out an efficient junction of an electroconductive
element 22 with a conductive coating 37 (see fig.7) this
latter being assumed as deposited over the surface of
a glass support $S_c$ according to a desired pattern, in
this example of embodiment, as recalled above. These novel characteristics may be specified as follows:

a) a final automatic and timed slide motion which is in-

0041928

- 11 -

dependent from the one to the other pointed rods also of a single pair 15-15 and 15'-15', so that an efficient brazing may be carried out by exploiting the heat generated by the Joule effect between said pointed rods as the end of each one may independently and rightly be adjusted onto the glass surface of any shape;

b) a rightly regulated pressure of each pointed rod on respective plane section 23 of electroconductive element 22, in order that the binding means 30 is flowing because of that generated heat in the brazing area, as a predetermined length of binding means 30 has been automatically interposed at the right time between electroconductive element 22 and conductive coating 37 deposited over the surface of glass support $S_c$;

c) a timed, modulated low voltage current is supplied to the pointed rods in order to provide and exploit the Joule effect therebetween in the brazing area of the electroconductive element to be brazed and thereby melt the binding means;

d) avoidance of negative effects which could be due to a superficial and eventually temporary coating of the pointed rod ends caused by repeated evaporations in the environment of same when repeated brazing operations are carried out, or by a superficial oxidization provided on the plane sections 23 of electroconductive element 22 wherein the pointed rods are acting, or furthermore due to the environment conditions when these electroconductive elements 22 have been stored.
Referring to above items a) and b) it is to recall here that the reciprocating motion of pointed rod-holders
and therefore that of pointed rods is pneumatically pro-
vided by respective units $C_3$-$C_3$ and $C_3'$-$C_3'$, the central
drive of which has the general reference character $P_3$
in system P with a compressed air reservoir $P_c$.
As premised, no detail has been shown in relation to
the central drive as well as electronic logic by which
the brazing device 10 is controlled according to a desired operational and timed planning.

A first initial downwards motion of device head 11 together with the component members of same is caused by cy-
linder-piston unit $C_2$, so that the pointed rods are ap-
proaching the conductive coating deposited over the surface of glass support $S_c$. When either pointed rods and
electroconductive element 22 already clamped between
shoulder 26 and hooked end of lever 27 have reached the
right position for a brazing operation, pointed rods
will further approach the electroconductive element 22
by owing to the control of cylinder-piston units $C_3$-$C_3$
and $C_3'$-$C_3'$. Pointed rod ends may thus press upon this ele-
ment independently of each other, according to the above mentioned novel characteristics of brazing device 10.
It is also important to point out that, while a relatively long strocke of each piston within respective cylinder is possible, only a portion of that strocke is actually utilized, in order that each pointed rod end may
act onto respective plane section 23 with some "elasticity" and consequently with a better adjustment on the shaped surface of the glass support.

This automatic behaviour of each pointed rod in regard to the pressure onto respective plane section 23 of electroconductive element 22 to be brazed for carrying out an efficient junction with the conductive coating deposited over the surface of glass support, performed through an intermediate binding means 30, is much more enhanced when each pointed rod end is properly shaped, as schematically shown in fig.5. Also the novel characteristic reported in above item d) is in this manner realized, as when such a shape of each pointed rod end is provided, the contact pressure results substantially independent of the pushing action upon the brazing area, so that the inflence of this parameter on the welding quantity is drastically reduced.

The detailed, while schematic, views of fig.5 show the cut end of a pointed rod 15 as suggested by many experiments of the Applicant just to avoid the negative effects as recalled hereabove.

Referring now to item c), a modulated low voltage is to be supplied to the pointed rods having the function of electrodes, and in accordance to the schematic view of fig.1 a transformer T is thereby provided, the primary input being supposed as an eight input primary which is generally supplied by a line power of 220 V, some other voltages being obviously possible while the transformer ratio is maintained. Also in accordance with these experiments, preferred different values of that modulated low voltage to be supplied range from about 2-2,5 V up to 3 V,
different supplying times being also provided. To properly regulate either modulation of low voltage and times of supplying same switching means $S_1$ and $S_2$ are pro-
vided, which are previously to be regulated according to
the selected programming. On the ground of above recalled experiments of the Applicant it was for example deduced that favourable conditions for an efficient brazing are resulting by supplying an initial low votage
of about 3 V for a time $t_1$ of 1 sec, afterwhich the supplying low voltage is abruptly lowered to about 2 to 2,5
V during a time $t_2$ of about 2 sec. In this manner, by
the Joule effect between the pointed rod ends a sufficient heat is generated in the brazing area to melt that
length of binding means which was in the meanwhile advanced and interposed automatically between plane section
23 of electroconductive element 22 and conductive coating 37 of glass support $S_c$.
As shown in figs.1 and 3, a foot-member 32 and a mechanical device are provided together to advance under the
electroconductive element 22 a predetermined length of
binding wires 30-30' to be melted during a brazing operation and then sharply separate the already welded
length of binding wire 30 from the remaining wire 30
which is to be used successively. This operation is fa-
voured by the action of cylinder-piston unit $C_5$. In fig.3
is also possible to notice that binding wires 30-30' are
sliding within corresponding sheathes 32 placed in foot-
member 32, while in fig.1 is shown that binding wire is supplied from a respective bobbin; and automatically advanced in a desired moment through that mechanical device and the action of cylinder-piston unit $C_6$. The binding wire may consist of conventional lead-tin compound.

Further referring to fig.1 it is to be added that the automatic and timed disposability of each electroconductive element 22 is to be occurred so that its tab 24 may justly be taken and clamped between shoulder 26 and the hook shaped end of lever 27. In this example of embodiment a vibrator-system is provided the section $V_c$ of which acts as a circular vibrator while section $V_1$ acts as a linear vibrator, through this latter being possible to canalize consecutively the electroconductive elements 22. A regulator 38 for circular vibrator $V_c$ and a regulator 39 for linear vibrator $V_1$ are also provided, this latter having also a photoelectric cell 40 to control the electroconductive elements in their consecutive alignment.

It is also important to point out that through a probe 41 (fig.1) which is connected to one end of the transformer secondary it is possible to evidence if the brazing operation goes off in the desired conditions or inefficiently because of abnormal current flow. That is to say, it is, in this manner, possible to value the brazing quality already during the brazing operation by inspecting the current flow between the pointed rods. It will indeed be understood by the skilled in the art that an eventual current flow different of a regular reference evidences some anomalies which may for example be due to an irregular condition of the surfaces to be welded, as men-
tioned above.

What we claim is:

1.  A method to braze an electroconductive element onto a conductive coating deposited over a bearing surface through an intermediate binding means interposed therebetween so that said electroconductive element may be used as a terminal to be connected to a power source, the method being characterized in that the junction of said electroconductive element with said conductive coating deposited over said bearing surface is provided by melting said binding means interposed therebetween in order that a single electroconductive body is formed, the heat to melt said binding means being generated in the brazing area because of the Joule effect provided between one or more pairs of suitably spaced pointed electrodes connected to a power source, these pairs of electrodes being suitably pressed onto said electroconductive element to be brazed, so that the circuit of the interconnected elements is in the ON state.

2.  A method according to Claim 1 wherein a low voltage current is supplied to the spaced pointed ends of the electrodes which are suitably pressed on said electroconductive element to be brazed, such a low voltage being automatically modulated in at least two consecutive values and times, an abrupt passage being provided from a higher value of said low voltage to a lower value of same, and the time of the former being independent of the latter.

3.  A method according to Claims 1 and 2, wherein coupled pointed electrodes are operating on said electroconductive element to be brazed and may initially be
moved together angularly along a plane, from an inactive
position to an active position which is suitable for a
brazing operation, a further sliding motion of these
electrodes being possible perpendicularly to the former
and indipendent from the one to the other electrode of
each pair, so that the pointed rod ends may act onto
said electroconductive element to be brazed after a right and indipendent adjustment upon the conductive coating of a bearing surface of any shape.

4. A device to braze an electroconductive element onto
a conductive coating deposited over a bearing surface
through an intermediate binding means being interposed
therebetween, wherein the melting of interposed binding
means is provided by the heat generated in the brazing
area because of the Joule effect between said electrodes
according to Claim 1, that device comprising:

a head (11) provided with the main component members
of device (10) suitable to carry out the brazing ope-
ration, said head (11) being connected to a carrying
bar (16) one end of which is mounted on axis (A-A) so
that said carrying bar (16) and connected head (11)
are revolving along a horizontal plane about axis (A-A)
to reach an inactive position or the operational posi-
tion, respectively, when the angular motion along a
horizontal plane is pneumatically controlled by a
cylinder-piston unit ($C_1$); said head (11) being also slidable perpendicularly of said revolving horizontal plane of same together with said main component members of device (10), according to the control of a cylinder-piston unit $(C_2)$;

at least a pair of electrodes which are shaped and suitably spaced as pointed rods (15-15) to be slided from a top inactive position to a bottom active or brazing position, and viceversa, when pneumatically controlled by cylinder-piston units $(C_3-C_3 ; C_3' -C_3')$;

a lever device (27) rotating about pin (28) and pneumatically controlled by a cylinder-unit $(C_4)$ in order to clamp the tab (24) of an electroconductive element (22) against a shoulder (26) when that electroconductive element (22) is to be brazed onto said conductive coating (37) deposited over said surface of bearing support $(S_c)$, so that such an electroconductive element may be rightly placed under said pointed rods (15-15) and brazed by same;

a device to automatically advance a predetermined length of said binding means (30) and interpose same between said electroconductive element (22) and said conductive coating (37) of bearing $(S_c)$, the timed advancement of that predetermined length of binding means being pneumatically controlled by a cylinder-piston unit $(C_6)$ together with a mechanical device.

5. A device according to Claim 4 wherein said cylinder-piston units $(C_1$ to $C_6)$ are operating by means of a system (P) which supplies compressed air thereto according to a central control, in order that automatic and timed functions of each cylinder-piston unit may be carried out.

6. A device according to Claims 4 and 5 wherein the low voltage current for pointed rods (15-15; 15'-15') which are operating to braze said electroconductive element (22) is supplied by the secundary of a transformer (T) the primary of which is connected to a line power, that low voltage being modulated in at least two timed values to be consecutively and automatically supplied to said pointed rods, an abrupt passage being provided from a highr value of said low voltage to a lower value of same, and the supply time of the former being generally shorter than the latter.

7. A device according to Claim 4 wherein said electroconductive elements to be consecutively brazed onto respective areas of said conductive coatings deposited over surfaces of bearing means are disposed in orderly alignment by means of a vibrating system (V), so that they are consecutively ready at the outlet of this latter in order to be taken and clamped between said shoulder (26) and the hooked end of said lever (27) when said pointed rods ends of head (11) are in the right position for a brazing operation.

8. A product obtained through the junction of an electroconductive element with a conductive coating deposited over a bearing surface, a binding means being interposed therebetween, such a product being characterized in that said junction is carried out by exploiting the heat generated in the area of the junction because of the Joule effect provided between the electrodes which are operating on said electroconductive element (22), when a modulated low voltage is supplied to said electrodes and the circuit is thereby in the ON state.

9. A method to braze an electroconductive element onto a conductive coating deposited over a bearing surface, a binding means being interposed therebetween to be melt by the heat generated in the junction area because of the Joule effect between said electrodes, as described referring to the accompanying drawings.

10. A device to carry out the brazing of an electroconductive element onto a conductive coating deposited over a bearing surface, a binding means being interposed therebetween to be melt by the heat generated in the brazing area because of the Joule effect between said pointed rods, as described referring to the accompanying drawings.

0041928

1/5

FIG. 1

FIG. 2

**FIG.3**

FIG.4

0041928

4/5

15

a

30°

b

45°

c

a′

b′

c′

**FIG.5**

24

22

25

a

23

b

24

23

25

24

23

25

23

c

**FIG.6**

15′

15

24

22

23

37

30

23

Sc

30′

**FIG.7**

European Patent Office

**EUROPEAN SEARCH REPORT**

## DOCUMENTS CONSIDERED TO BE RELEVANT

| Category | Citation of document with indication, where appropriate, of relevant passages | Relevant to claim |
|---|---|---|
| A | <u>DE - A - 2 629 496 </u>(SIEMENS A.G.)<br><br>* Claims; figure 1 *<br><br>-- | 1,8-10 |
| A | <u>DE - B - 1 263 121 </u>(TEXAS INSTRU-<u>MENTS INC.</u>)<br><br>* Claims; figures 7,8 *<br>& GB - A - 1 141 075<br><br>---- | 1,8 |

**CLASSIFICATION OF THE APPLICATION (Int. Cl.³)**

H 05 K 13/04

**TECHNICAL FIELDS SEARCHED (Int Cl.⁴)**

H 05 K 13/04
H 01 L 21/60
H 01 R 43/02
B 23 K 1/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family. corresponding document

The present search report has been drawn up for all claims

| Place of search | Date of completion of the search | Examiner |
|---|---|---|
| The Hague | 10-07-1981 | VAN REETH |

EPO Form 1503.1   06.78